(19) Europäisches Patentamt
European Patent Office
Office européen des brevets

(11) **EP 1 191 345 B1**

(12) **EUROPÄISCHE PATENTSCHRIFT**

(45) Veröffentlichungstag und Bekanntmachung des Hinweises auf die Patenterteilung:
**19.04.2006 Patentblatt 2006/16**

(51) Int Cl.:
*G01R 33/3815* *(2006.01)*    *G01R 33/421* *(2006.01)*

(21) Anmeldenummer: **01117072.7**

(22) Anmeldetag: **13.07.2001**

(54) **Magnetanordnung mit einem supraleitenden Magnetspulensystem und einer ferromagnetischen Feldform-Vorrichtung**

Magnet assembly comprising a superconducting magnet coil system and ferromagnetic means for homogenizing the magnetic field

Arrangement d'aimants supraconducteurs comportant des moyens ferromagnétiques pour homogéniser le champ magnétique

(84) Benannte Vertragsstaaten:
**CH DE FR GB LI**

(30) Priorität: **19.09.2000 DE 10046182**

(43) Veröffentlichungstag der Anmeldung:
**27.03.2002 Patentblatt 2002/13**

(73) Patentinhaber: **Bruker BioSpin AG
8117 Fällanden (CH)**

(72) Erfinder:
• **Schauwecker, Robert
8032 Zürich (CH)**
• **Bovier, Pierre-Alain
8051 Zürich (CH)**
• **Eckert, Daniel M.
8600 Dübendorf (CH)**
• **Laukien, Frank H.
Lincoln, MA 01773 (US)**

(74) Vertreter: **Kohler Schmid Möbus
Patentanwälte
Ruppmannstrasse 27
70565 Stuttgart (DE)**

(56) Entgegenhaltungen:
**US-A- 4 612 505**      **US-A- 4 968 961**
**US-A- 5 012 217**      **US-A- 5 309 106**
**US-A- 5 659 281**      **US-A- 5 994 991**

• **MEEROVICH V ET AL: "A hybrid magnetic shield employing ferromagnetic iron and HTSC rings" INST. PHYS. CONF. SER., Bd. 158, 1997, Seiten 1651-1654, XP009039604**
• **HUSON F R ET AL: "A HIGH-FIELD SUPERFERRIC NMR MAGNET" MAGNETIC RESONANCE IN MEDICINE, ACADEMIC PRESS, DULUTH, MN, US, Bd. 29, Nr. 1, 1993, Seiten 25-31, XP000345556 ISSN: 0740-3194**

**Beschreibung**

Die Erfindung betrifft eine Magnetanordnung mit einem supraleitenden Magnetsputensystem zur Erzeugung eines Magnetfeldes in Richtung einer z-Achse in einem auf der z-Achse um z = 0 angeordneten Arbeitsvolumen, wobei das Feld der Magnetanordnung im Arbeitsvolumen (AV) einen Anteil H2 (= H2-Inhomogenität) aufweist, der entlang der z-Achse eine quadratische Ortsabhängigkeit aufweist, wobei das supraleitende Magnetspulensystem ein radial inneres Teilspulensystem und ein dazu koaxiales radial äußeres Teilspulensystem umfasst, sowie mit einer um die z-Achse insbesondere zylindersymmetrisch angeordneten Feldform-Vorrichtung aus ferromagnetischem Material, welche sich radial zwischen dem radial inneren und dem radial äußeren Teilspulensystem befindet und mit den beiden Teilspulensystemen koaxial ist, wobei das radial innere Teilspulensystem im Arbeitsvolumen ein Feld mit einer verschwindend kleinen H2-Inhomogenität, d.h. ein homogenes Feld erzeugt, während das radial äußere Teilspulensystem für sich gesehen im Arbeitsvolumen ein Feld mit einer großen H2-Inhomogenität, d.h. ein inhomogenes Feld erzeugt, sowie ein Verfahren zur Dimensionierung der ferromagnetischen Feldform-Vorrichtung.

Eine supraleitende Magnetanordnung mit einem radial inneren und einem radial äußeren Teilspulensystem sowie einer magnetischen Abschirmung, bei welcher das Magnetfeld des radial inneren Teilspulensystems homogen ist, ist bekannt aus der US-A 4'587'504 (Re. 36'782).

Eine supraleitende Magnetanordnung mit einem radial inneren und einem radial äußeren Teilspulensystem sowie einer zylindersymmetrischen magnetischen Abschirmung radial zwischen den beiden Teilspulensystemen, bei welcher das Magnetfeld des radial äußeren Teilspulensystems inhomogen ist, ist bekannt aus der US-A 5'012'217. Dieses Dokument offenbart eine Magnetanordnung gemäß dem Obergegriff des Anspruchs 1.

Das Einsatzgebiet von supraleitenden Magnetspulensystemen umfasst verschiedene Anwendungsfelder, insbesondere die Magnetresonanzverfahren, in weichen in der Regel die örtliche Homogenität des Magnetfeldes im Arbeitsvolumen der Magnetanordnung wichtig ist. Zu den anspruchsvollsten Anwendungen gehört die hochauflösende Kernresonanz-Spektroskopie (NMR-Spektroskopie). Typischerweise wird angestrebt, dass die Magnetfeldstärke über einen Bereich von 50 bis 60 mm entlang der Achse des Magnetspulensystems um weniger als 10 ppm der Feldstärke im Arbeitsvolumen variiert. Die Maßnahmen zur Homogenisierung des Feldes des Magnetspulensystems bewirken, dass das Spulenvolumen vergrößert wird. Dieser Umstand und die typischerweise sehr hohen Feldstärken führen dazu, dass Spulensysteme für Magnetresonanzanwendungen ein großes magnetisches Dipolmoment aufweisen und daher ein großes Streufeld erzeugen. Um diesem Streufeld entgegenzuwirken, können supraleitende Teilspulensysteme angebracht werden, welche das Dipolmoment des Hauptspulensystems kompensieren (aktiv abgeschirmtes Magnetspulensystem). Eine zusätzliche Streufeldreduktion kann mit einer magnetischen Abschirmung erreicht werden. Die Maßnahmen zur Streufeldreduktion dürfen die Feldhomogenität im Arbeitsvolumen der Magnetanordnung nicht beeinträchtigen.

Die US-A 4'587'504 (Re. 36'782) beschreibt ein aktiv abgeschirmtes Magnetspulensystem für Kernresonanzanwendungen, in welchem die Feldhomogenität im Arbeitsvolumen entweder dadurch erreicht wird, dass das Hauptspulensystem und das Abschirmspulensystem je einzeln homogenisiert werden, oder dass die beiden Teilspulensysteme ihre inhomogenen Feldbeiträge gegenseitig kompensieren. Die erste Ausführungsform zielt darauf ab, die resultierende Feldhomogenität im Arbeitsvolumen besser zu kontrollieren, während die zweite Ausführungsform den Bau eines kompakteren Magnetspulensystems erlaubt. Mit einer zusätzlichen magnetischen Abschirmung wird die Streufeldunterdrükkung optimiert, ohne dass damit die Feldhomogenität im Arbeitsvolumen beeinflusst würde.

In der US-A 5'012'217 wird eine aktiv abgeschirmte supraleitende Magnetanordnung mit zusätzlicher magnetischer Abschirmung beschrieben, bei welcher das Magnetfeld im Arbeitsvolumen, welches das Magnetspulensystem allein generiert, inhomogen ist und erst durch den Feldbeitrag der magnetischen Abschirmung homogenisiert wird. Indem die magnetische Abschirmung zur Feldhomogenisierung genutzt wird, können kompaktere Magnetsysteme gebaut werden. Die Feldinhomogenität des Magnetspulensystems rührt typischerweise sowohl vom Hauptspulensystem als auch vom Abschirmspulensystem her. Die magnetische Abschirmung befindet sich teilweise radial zwischen den beiden Teilspulensystemen. Dies erlaubt eine Reduktion der Ampärewindungszahl des Abschirmspulensystems gegenüber einer anderen Anordnung der magnetischen Abschirmung.

US-A-5'659'281 beschreibt eine Magnetanordnung, welche mehrere Teilspulensysteme und auch eine ferromagnetische Abschirmung umfassen kann. Die Anordnung wird für bildgebende Kernspinresonanzanwendungen in der medizinischen Diagnostik eingesetzt. Die Spulen sind so konfiguriert, dass das Arbeitsvolumen, also jener Bereich, wo das Magnetfeld für die Anwendung ausreichend stark und homogen ist, axial außerhalb der Spulenanordnung liegt. Ferromagnetisches Material kann zur Reduktion des Streufeldes der Anordnung angebracht werden und sein Einfluss auf die Feldhomogenität wird berücksichtigt.

Der Einsatz von magnetischen Abschirmungen in aktiv abgeschirmten Magnetanordnungen nach dem zitierten Stand der Technik zielt darauf ab, die Streufeldunterdrückung der aktiv abgeschirmten Magnetanordnung zu verbessern und dabei auch die Feldhomogenisierung im Arbeitsvolumen zu vereinfachen. Demgegenüber ist es die Aufgabe der vorliegenden Erfindung, dass ein homogenisiertes aber nicht aktiv abgeschirmtes Magnetspulensystem (im Weiteren das radial innere Teilspulensystem genannt) mit einem nicht homogenisierten, radial äußeren Teilspulensystem ergänzt werden kann, so dass, unter Einsatz einer ferromagnetischen Feldform-Vorrichtung, die gesamte resultierende Magnetanordnung wiederum ein homogenes Magnetfeld im Arbeitsvolumen der Magnetanordnung erzeugt. Beispielsweise handelt es sich beim radial äußeren Teilspulensystem um eine aktive Streufeldkompensation.

Erfindungsgemäß wird diese Aufgabe durch eine Magnetanordnung gemäß Anspruch 1 gelöst, Insbesondere erzeugt das radial äußere Teilspulensystem zusammen mit der ferromagnetischen Feldform-Vorrichtung im Arbeitsvolumen ein Feld mit einer verschwindend kleinen H2-Inhomogenität (=homogenes Feld). Damit die ferromagnetische Feldform-Vorrichtung zur Homogenisierung des radial äußeren Teilspulensystems genutzt werden kann, muss der genaue Verlauf des von ihr erzeugten Feldes im Arbeitsvolumen berechnet werden können. Daher ist es insbesondere wichtig, dass keine magnetischen Hysterese- oder Remanenzeffekte auftreten und dass einfache und genaue Berechnungsalgorithmen für das Profil des Feldes der ferromagnetischen Feldform-Vorrichtung im Arbeitsvolumen angewendet werden können.

Dieses Teilproblem wird bei der Erfindung dadurch gelöst, dass das radial innere und äußere Teilspulensystem so ausgelegt sind, dass es im radialen Zwischenraum zwischen den beiden Teilspulensystemen einen Bereich gibt, wo das Magnetfeld weitgehend in eine Richtung entlang der Achse der Magnetanordnung weist und seine Stärke ausreicht, um das verwendete magnetische Material magnetisch zu sättigen, und dass die ferromagnetische Feldform-Vorrichtung in diesem Bereich angebracht wird.

Ein Hauptvorteil der Eigenschaft einer erfindungsgemäßen Anordnung, dass die ferromagnetische Feldform-Vorrichtung und das radial äußere Teilspulensystem zusammen im Arbeitsvolumen ein homogenes Magnetfeld erzeugen, besteht darin, dass bereits bestehende radial innere Teilspulensysteme mit der Vorrichtung aus radial äußerem Teilspulensystem und magnetischer Anordnung nachgerüstet werden können, oder dass eine Variantenproduktion mit oder ohne radial äußerem Teilspulensystem und ferromagnetischer Feldform-Vorrichtung möglich ist. Beispielsweise können Magnetanordnungen mit oder ohne Streufeldkompensation produziert werden, basierend auf demselben radial inneren Teilspulensystem. Dass die. Homogenisierung des radial äußeren Teilspulensystems mit der ferromagnetischen Feldform-Vorrichtung vorgenommen wird, hat den Vorteil, dass das radial äußere Teilspulensystem einfach strukturiert werden kann, typischerweise als eine einzige Solenoidspule. Die magnetische Sättigung der ferromagnetischen Feldform-Vorrichtung und die Ausrichtung ihrer Magnetisierung entlang der Achse der Magnetanordnung sowie die Zylindersymmetrie der ferromagnetischen Feldform-Vorrichtung erlauben, dass ihr Magnetfeld durch das Feld von Zylinderoberflächenströmen simuliert werden kann, womit das Feld einfach und exakt berechnet werden kann.

Besonders bevorzugt ist eine Ausführungsform der erfindungsgemäßen Magnetanordnung, bei der das radial innere und äußereTeilspulensystem elektrisch in Serie geschaltet sind und einen einzigen, mit einem supraleitenden Schalter überbrückten Strompfad bilden. In einer solchen Magnetanordnung ist ohne weitere Maßnahmen gewährleistet, dass in beiden Teilspulensystemen betragsmäßig der gleiche Strom fließt.

Vorteilhaft ist auch eine Ausführungsform der erfindungsgemäßen Magnetanordnung, bei der das radial innere und äußereTeilspulensystem elektrisch getrennt sind und je einen eigenen, mit einem supraleitenden Schalter überbrückten Strompfad bilden. In einer solchen Magnetanordnung ist es möglich, den Strom in den einzelnen Teilspulensystemen individuell zu verändern.

Bei zwei Weiterbildungen dieser Ausführungsform wird entweder das radial äußere Teilspulensystem im Betriebszustand durch das radial innere Teilspulensystem induktiv geladen, oder das radial innere Teilspulensystem und das radial äußere Teilspulensystem können wahlweise mit einem Strom gleicher oder entgegengesetzter Polarität geladen werden. Der Vorteil der ersten Weiterbildung besteht darin, dass das radial äußere Teilspulensystem in sich supraleitend geschlossen werden kann. Die zweite Weiterbildung ist vorteilhaft, weil entsprechend den individuellen Bedürfnissen des Anwenders der Magnetanordnung durch das radial äußere Spulensystem wahlweise entweder das Streufeld der Magnetanordnung reduziert, oder aber das Feld im Arbeitsvolumen verstärkt werden kann, sofern am Ort der ferromagnetischen Feldform-Vorrichtung der Feldbeitrag des radial äußeren Teilspulensystems gegenüber demjenigen des radial inneren dominiert.

Eine besonders bevorzugte Ausführungsform der erfindungsgemäßen Magnetanordnung zeichnet sich dadurch aus, dass die beiden Teilspulensysteme im Arbeitsvolumen je ein Magnetfeld mit entgegengesetzter Richtung entlang der Achse der Magnetanordnung erzeugen. Mit einer solchen Anordnung lässt sich das Streufeld des radial inneren Teilspulensystems reduzieren. Der erfindungsgemäße Einsatz einer magnetischen, insbesondere ferromagnetischen, Feldform-Vorrichtung radial zwischen den beiden Teilspulensystemen hat in dieser Anordnung den besonderen Vorteil, dass sie einerseits das radial innere Teilspulensystem gegen außen hin abschirmt, also das Streufeld reduziert, und dass sie andererseits das radial äußere Teilspulensystem gegen das Arbeitsvolumen der Magnetanordnung hin abschirmt, also bewirkt, dass das Feld im Arbeitsvolumen durch das radial äußere Spulensystem weniger stark reduziert wird. Somit kann einerseits im radial äußeren Teilspulensystem supraleitender Draht eingespart werden, und andererseits muss der Strom im radial inneren Teilspulensystem weniger stark-erhöht werden, um die Feldstärke im Arbeitsvolumen zu halten.

Eine vorteilhafte Weiterbildung der obigen Ausführungsform sieht vor, dass das radial innere Teilspulensystem ein entgegengesetzt gleiches magnetisches Dipolmoment aufweist wie das radial äußere Teilspulensystem zusammen mit der ferromagnetischen Feldform-Vorrichtung. Wenn diese Bedingung erfüllt ist, heben sich die beiden Feldbeiträge außerhalb der Magnetanordnung weitgehend auf und das Streufeld der Magnetanordnung ist praktisch ideal kompensiert.

Vorteilhaft ist auch eine Ausführungsform der erfindungsgemäßen Magnetanordnung, bei der die ferromagnetische Feldform-Vorrichtung aus einem Ring der axialen Länge *LP* mit Innenradius *RiP* besteht, wobei *LP* gleich *RiP* ist. In dieser Ausführungsform der ferromagnetischen Feldform-Vorrichtung können Feldinhomogenitäten des radial äußeren Teilspulensystems, welche entlang der Achse der Magnetanordnung eine quadratische Ortsabhängigkeit aufweisen, mit maximaler Effizienz, also unter Einsatz einer minimalen Menge an magnetischem Material, kompensiert werden.

Bei einer weiteren vorteilhaften Ausführungsform der erfindungsgemäßen Magnetanordnung besteht die ferromagnetische Feldform-Vorrichtung aus zwei Ringen der axialen Länge *LQ* mit Innenradius *RiP*, welche im Abstand *DQ* symmetrisch um die Mittelebene der Magnetanordnung angeordnet sind, wobei *DQ < 0.5·RiP* und *(DQ + 2 LQ)* gleich *RiP* ist. In dieser Ausführungsform der ferromagnetischen Feldform-Vorrichtung können Feldinhomogenitäten des radial äußeren Teilspulensystems, welche entlang der Achse der Magnetanordnung eine quadratische Ortsabhängigkeit aufweisen, effizient kompensiert werden. Zusätzlich kann ein Feldanteil, welcher entlang der Achse der Magnetanordnung eine höhere als quadratische Ortsabhängigkeit aufweist, ebenfalls kompensiert werden.

Eine besonders bevorzugte Ausführungsform der erfindungsgemäßen Magnetanordnung zeichnet sich dadurch aus, dass das radial äußere Teilspulensystem aus einer Solenoidspule der axialen Länge *LC2* mit Innenradius *RiC2* besteht, wobei *LC2* näherungsweise gleich groß wie oder größer als der doppelte Innenradius *RiC2* ist. In einer solchen Anordnung ist der Bereich, in dem das Magnetfeld weitgehend in eine Richtung entlang der Achse der Magnetanordnung weist und seine Stärke ausreicht, um das verwendete magnetische Material magnetisch zu sättigen, typischerweise besonders groß. Außerdem ist die Ausführungsform des radial äußeren Spulensystems als Solenoidspule fertigungstechnisch besonders vorteilhaft. In dieser Ausführungsform zahlt sich also die Homogenisierung des radial äußeren Spulensystems durch die ferromagnetische Feldform-Vorrichtung besonders aus, weil auf komplizierte Homogenisierungsstrukturen im Spulensystem verzichtet werden kann.

In einer weiteren Ausführungsform zeichnet sich die Magnetanordnung dadurch aus, dass sie Teil einer Apparatur zur hochauflösenden Magnetresonanzspektroskopie ist. In einer solchen Magnetanordnung sind die Anforderungen an die Homogenität des Feldes im Arbeitsvolumen besonders hoch und die Eigenschaft einer erfindungsgemäßen Magnetanordnung, dass sich der Feldbeitrag der ferromagnetischen Feldform-Vorrichtung im Arbeitsvolumen ebenso genau berechnen lässt wie derjenige der Spulensysteme, ist in einer solchen Anordnung besonders vorteilhaft.

In den Rahmen der vorliegenden Erfindung fällt auch ein Verfahren zur Dimensionierung einer ferromagnetischen Feldform-Vorrichtung, wobei die ferromagnetische Feldform-Vorrichtung Teil einer Magnetanordnung nach einem der Ansprüche 1-5 ist, wobei die ferromagnetische Feldformvorrichtung magnetisch gesättigt, in Richtung entlang der z-Achse magnetisiert und bezüglich der z-Achse zylindersymmetrisch ist, dadurch gekennzeichnet, dass die ferromagnetische Feldform-Vorrichtung so dimensioniert wird, dass die Feldinhomogenitäten $H_n(C2)$ des radial äußeren Teilspulensystems, welche entlang der Achse z der Magnetanordnung eine Ortsabhängigkeit *n*-ter Potenz aufweisen, für $n = 1, 2, 3$ und $4$ durch entsprechende Feldinhomogenitäten $H_n(P) = -H_n(C2)$ der ferromagnetischen Feldform-Vorrichtung kompensiert werden, wobei die Feldinhomogenitäten $H_n(P)$ berechnet werden, indem auf jeder radial innen und auf jeder radial außen liegenden Oberfläche $S = SI_k$ beziehungsweise $S = SA_m$ der ferromagnetischen Feldform-Vorrichtung ein zylindrischer Oberflächenstrom $J_s$ angenommen wird, dessen Beitrag $H_n(S)$ zur Feldinhomogenität $H_n(P)$

$$H_n(S)\left[\frac{T}{m^n}\right] = \frac{\mu_0 \cdot J_s}{R_s^n}\left(Y_n\left(\frac{z1_s}{R_s}\right) - Y_n\left(\frac{z2_s}{R_s}\right)\right)$$

beträgt, mit

$$J_s\left[\frac{A}{m}\right] = \begin{cases} -sign(M_z) \cdot \dfrac{M_{Sat}}{\mu_0} \text{ für } S = SI_k \\[2mm] sign(M_z) \cdot \dfrac{M_{Sat}}{\mu_0} \text{ für } S = SA_m \end{cases}$$

$$\mu_0 = 4\pi \cdot 10^{-7} \left[ \frac{Vs}{Am} \right]$$

$sign(M_z)$: Vorzeichen der axialen Magnetisierung des Materials der ferromagnetischen Feldform-Vorrichtung,
$M_{Sat}$ [$T$]: Sättigungsmagnetisierung des Materials der ferromagnetischen Feldform-Vorrichtung,
$R_S$ [$m$]: Radius der Zylinderfläche $S$,
$z1_S$ [$m$]: Abstand der Unterkante der Zylinderfläche $S$ zu $z = 0$,
$z2_S$ [$m$]: Abstand der Oberkante der Zylinderfläche $S$ zu $z = 0$,

$$Y_1(x) = \frac{1}{2(x^2 + 1)^{3/2}},$$

$$Y_2(x) = \frac{3x}{4(x^2 + 1)^{5/2}},$$

$$Y_3(x) = \frac{(4x^2 - 1)}{4(x^2 + 1)^{7/2}},$$

$$Y_4(x) = \frac{5x(4x^2 - 3)}{16(x^2 + 1)^{9/2}},$$

und indem die Beiträge $H_n(S)$ aller Oberflächenströme $J_S$ addiert werden. Der Vorteil dieses Vefahrens besteht darin, dass die Feldinhomogenitäten $H_n(P)$ der ferromagnetischen Feldform-Vorrichtung exakt berechnet werden können.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

Fig. 1 einen schematischen Vertikalschnitt durch eine radiale Hälfte der erfindungsgemäßen Magnetanordnung;

Fig. 2 einen schematischen Vertikalschnitt durch eine radiale Hälfte der erfindungsgemäßen Magnetanordnung mit einer besonders bevorzugten Ausführungsform der ferromagnetischen Feldform-Vorrichtung $P$;

Fig. 3: einen schematischen Vertikalschnitt durch eine radiale Hälfte einer erfindungsgemäßen ferromagnetischen Feldform-Vorrichtung $P$ in Form mehrerer konzentrischer Ringe.

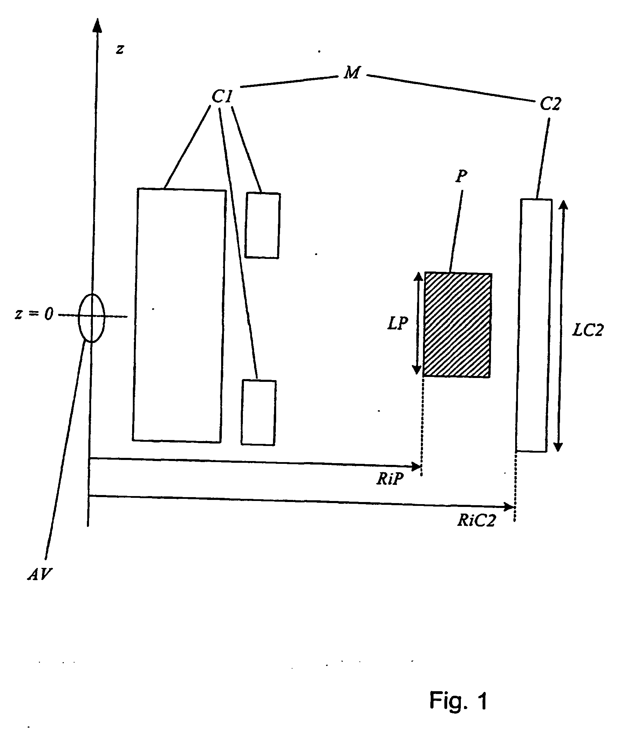

Anhand der Figur 1 wird eine erfindungsgemäße Magnetanordnung gezeigt, welche um ein Arbeitsvolumen $AV$ angeordnet ist und ein Magnetspulensystem $M$ mit einem radial inneren und einem radial äußeren, koaxialen Spulensystem $C1$ und $C2$ sowie eine ferromagnetische Feldform-Vorrichtung $P$ in Form eines Ringes umfasst. $LP$ beziehungsweise $LC2$ bezeichnet die axiale Länge der Feldform-Vorrichtung $P$ beziehungsweise des radial äußeren Spulensystems $C2$. $RiP$ beziehungsweise $RiC2$ bezeichnet den Innenradius der Feldform-Vorrichtung $P$ beziehungsweise des radial äußeren Spulensystems $C2$.

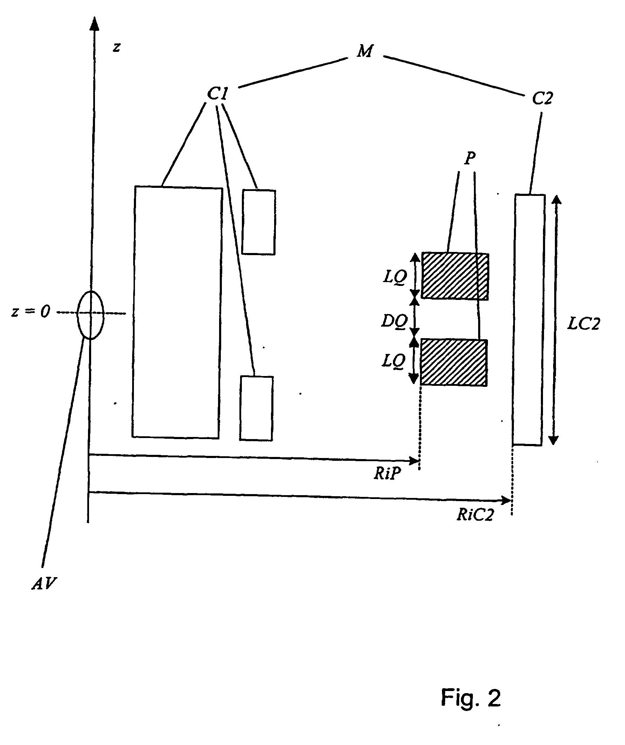

Anhand der Figur 2 wird eine besonders bevorzugte Ausführungsform der ferromagnetischen Feldform-Vorrichtung $P$ gezeigt, welche zwei um $z = 0$ zentrierte Ringe im Abstand $DQ$ umfasst. $LQ$ beziehungsweise $LC2$ bezeichnet die axiale Länge der Feldform-Vorrichtungsringe beziehungsweise des radial äußeren Spulensystems $C2$. $RiP$ beziehungsweise $RiC2$ bezeichnet den Innenradius der Feldform-Vorrichtungsringe beziehungsweise des radial äußeren Spulensystems $C2$.

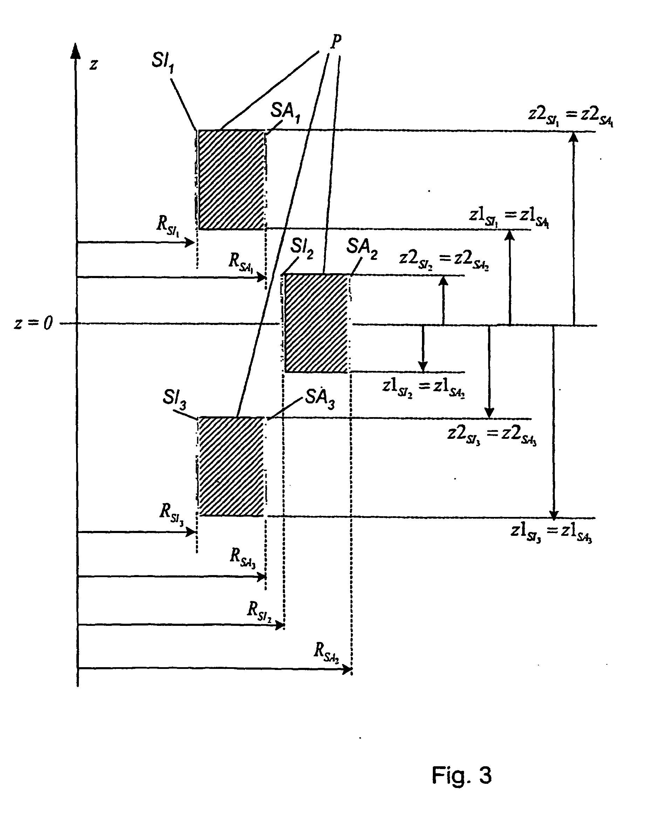

Anhand der Figur 3 wird eine ferromagnetischen Feldfonn-Vorrichtung $P$ in Form mehrerer-konzentrischer Ringe gezeigt, mit den radial innen beziehungsweise außen liegenden zylindrischen Oberflächen $SI_1$, $SI_2$, $SI_3$ beziehungsweise $SA_1$, $SA_2$, $SA_3$. Die Größen $R_{SIk}$ beziehungsweise $R_{SAk}$ ($k = 1, 2, 3$) bezeichnen die Radien der zylindrischen Oberflächen. Die Größen $z1_{SIk} = z1_{SAk}$, ($k = 1, 2, 3$), bezeichnen den Abstand der Unterkante der Zylinderfläche $SI_k$ beziehungsweise $SA_k$ zu $z = 0$. Die Größen $z2_{SIk} = z2_{SAk}$, ($k = 1, 2, 3$), bezeichnen den Abstand der Oberkante der Zytinderfläche $SI_k$ beziehungsweise $SA_k$ zu $z = 0$.

Im Folgenden wird die Erfindung anhand von verschiedenen Ausführungsformen einer supraleitenden Magnetanordnung erläutert, welche im Arbeitsvolumen $AV$ je ein Magnetfeld der Stärke 9.40 Tesla erzeugen. Diese Feldstärke wird häufig in Kernresonanzapparaturen eingesetzt. Sie entspricht einer Protonenresonanzfrequenz von 400 MHz. Als Supraleitermaterial wird Niob-Titan eingesetzt. Der Magnet wird in einem Flüssighelium-Bad betrieben bei einer Temperatur von 4.2 Kelvin.

Eine typische Ausführungsform (im Weiteren Ausführungsform "$A1$" genannt) einer solchen Magnetanordnung umfasst ein Magnetspulensystem M mit mehreren konzentrischen, koaxialen Solenoidspulen, welche alle die gleiche Polarität aufweisen, wobei die Spulen so strukturiert und konfiguriert sind, dass der Feldverlauf der Magnetanordnung im Arbeitsvolumen $AV$ den Homogenitätsanforderungen für Kernresonanzanwendungen genügt. Bei der Ausführungsform $A1$ handelt es sich somit um ein Magnetspulensystem ohne Vorrichtungen zur Kompensation des Streufeldes. Die freie Innenbohrung hat einen Durchmesser von 70 Millimetern.

Mit dem Ziel, das Streufeld dieser Magnetanordnung zu reduzieren, kann ein entgegengesetzt polarisiertes, zusätzliches Teilspulensystem radial außerhalb des ursprünglichen Spulensystems angebracht und mit diesem elektrisch in Serie geschaltet werden. Das ursprüngliche, radial innere Teilspulensystem wird im Weiteren "Hauptspule $C1$" genannt, das radial äußere "aktive Abschirmung $C2$". Diese Ausführungsform wird im Weiteren "$A2$" genannt.

Mit der Variante $A2$ wird eine erfindungsgemäße Variante (im Weiteren "$A3$" genannt) verglichen, welche zusätzlich zur aktiven Abschirmung $C2$ eine magnetisch gesättigte, in einer Richtung entlang der Magnetachse magnetisierte, ferromagnetische Feldform-Vorrichtung $P$ umfasst. Die ferromagnetische Feldform-Vorrichtung $P$ wird zur Homogenisierung der aktiven Abschirmung C2 genutzt.

Die Tabelle 1 zeigt einen Vergleich der wichtigsten Merkmale der Ausführungsformen $A1$, $A2$ und $A3$.

**Tabelle 1**

|  | $A1$ | $A2$ | $A3$ |
|---|---|---|---|
| $B$ [Tesla] | 9.40 | 9.40 | 9.40 |
| $I$ [Ampère] | 98.0 | 107.7 | 105.7 |
| $L$ [Henry] | 40.6 | 37.0 | 35.6 |
| $E$ [Kilojoule] | 195 | 215 | 199 |
| $Z10$ [Millimeter] | 56 | 56 | 56 |
| $R5G$ [Meter] | 2.27 | 0.79 | 0.77 |
| $LWC2$ [Meter] | - | 6088 | 4719 |

In der Tabelle 1 bezeichnen:

$B$ die Magnetfeldstärke im Arbeitsvolumen $AV$,
$I$ den Strom im gesamten Magnetspulensystem,
$L$ die Induktivität des gesamten Magnetspulensystems,
$E$ die Feldenergie des gesamten Magnetspulensystems,
$Z10$ die Länge des Bereichs entlang der Magnetachse, in welchem die Feldstärke um weniger als 10 ppm vom Maximalwert abweicht,
$R5G$ den Abstand von der Magnetachse, bei welchem auf Höhe der Magnetmittelebene das Streufeld der Magnetanordnung den Wert von 0.5 Millitesla unterschreitet,
$LWC2$ die Länge des in der aktiven Abschirmung gewickelten Supraleiterdrahtes.

Damit die drei Ausführungsformen $A1$, $A2$ und $A3$ miteinander verglichen werden können, wurden sie so ausgelegt, dass das Magnetfeld im Arbeitsvolumen und die Feldhomogenität in allen Fällen gleich sind. Die Wirkung der Vorrichtung zur Streufeldkompensation in den Ausführungsformen $A2$ und $A3$ zeigt sich in der Verkleinerung des Abstandes von der Magnetachse, ab welchem die Streufeldstärke von 0.5 Millitesla unterschritten wird, auf etwa ein Drittel des ursprünglichen Wertes. Für die beiden abgeschirmten Magnetanordnungen muss daher nur etwa 10 Prozent derjenigen Laborfläche zur Verfügung stehen, welche von der unabgeschirmten Magnetanordnung eingenommen wird.

Der Vergleich der Variante *A2* mit der erfindungsgemäßen Variante *A3* zeigt, dass - bei gleich starker Kompensation des Streufeldes - durch den Einsatz der ferromagnetischen Feldform-Vorrichtung die Drahtmenge in der aktiven Abschirmung *C2* erheblich reduziert werden kann und die Erhöhung des Stromes gegenüber der unabgeschirmten Anordnung *A1* kleiner ausfällt. Der Gewinn beträgt 20 bis 25 Prozent gegenüber Variante *A2*. Besonders vorteilhaft wirkt sich die ferromagnetische Feldform-Vorrichtung auf die Feldenergie im Magnetspulensystem aus, welche in der Ausführungsform *A3* nur um 2 Prozent zunimmt gegenüber der Feldenergie der Ausführungsform *A1*, statt um 10 Prozent im Falle der Variante *A2*.

Weil die Hauptspule *C1* in allen drei Ausführungsformen *A1*, *A2* und *A3* im Arbeitsvolumen ein homogenes Feld erzeugt, muss die Streufeldabschirmung, bestehend aus der aktiven Abschirmung *C2* im Falle *A2* beziehungsweise aus der aktiven Abschirmung *C2* und der ferromagnetischen Feldform-Vorrichtung *P* im Falle *A3*, insgesamt auch ein homogenes Feld erzeugen, damit das resultierende Feld der gesamten Anordnung ebenfalls homogen ist. In der Variante *A2* wird dies dadurch erreicht, dass die aktive Abschirmung *C2* aus drei koaxialen Solenoidspulen aufgebaut ist. Durch geeignete Wahl der Längen und der axialen Positionen der Solenoidspulen kann die verlangte Feldhomogenität im Arbeitsvolumen erzielt werden.

in der erfindungsgemäßen Magnetanordnung *A3* besteht dagegen die aktive Abschirmung *C2* aus einem einzigen Solenoid mit Innenradius 0.2 Meter und axialer Länge 0.4 Meter, welches symmetrisch um die Mittelebene der Magnetanordnung angebracht wird. Eine solche Ausführungsform der aktiven Abschirmung *C2* ist mit wesentlich geringerem Aufwand zu realisieren als eine Variante gemäß der Ausführungsform *A2*. Das Solenoid umfasst 3720 Drahtwindungen, in welchen je ein Strom von 105.7 Ampere fließt.

Die Ortsabhängigkeit der Feldstärke $B_{C2}$ dieser Spule entlang der Magnetachse kann durch ein Polynom beschrieben werden:

$$B_{C2}(z) = H_0(C2) + H_2(C2) \cdot z^2 + H_4(C2) \cdot z^4 + H_6(C2) \cdot z^6 + \dots ,$$

wobei *z* der axiale Abstand vom Zentrum des Arbeitsvolumens *AV* der Magnetanordnung ist. Die Beiträge vierter oder höherer Ordnung sind für die aktive Abschirmung *C2* der Magnetanordnung *A3* so klein, dass sie sich im Arbeitsvolumen *AV* nicht auf das Feldprofil auswirken. Im Wesentlichen macht diese Spule also ein Magnetfeld, dessen Stärke im Bereich des Arbeitsvolumens *AV* der Magnetanordnung entlang der Magnetachse eine Parabel beschreibt. Für den Einsatz in einer Kernresonanzapparatur ist ein solches Feldprofil ungenügend. Typischerweise wird verlangt, dass die Terme zweiter und vierter Ordnung im Wesentlichen null sind.

In einer erfindungsgemäßen Magnetanordnung wird die Inhomogenität der aktiven Abschirmung *C2* durch die ferromagnetische Feldform-Vorrichtung *P* kompensiert. Im Falle der Magnetanordnung *A3* bedeutet dies, dass der parabolische Feldanteil $H_2(C2)$ der aktiven Abschirmung *C2* durch einen entgegengesetzt gleich starken Anteil $H_2(P)$ = $-H_2(C2)$ der magnetschen Feldform-Vorrichtung *P* kompensiert werden muss. Für die oben beschriebene Solenoidspule beträgt $H_2(C2)$ 0.82 Millitesla/cm². Diese Inhomogenität wird in der Ausführungsform *A3* durch eine, mit dem Magnetspulensystem koaxiale, ferromagnetische Feldform-Vorrichtung *P* in der Form eines Hohlzylinders kompensiert, wobei der Innenradius 0.148 Meter und der Außenradius 0.175 Meter beträgt und die Länge 0.213 Meter misst. Die ferromagnetische Feldform-Vorrichtung *P* besteht aus Weicheisen und ist symmetrisch um die Mittelebene der Magnetanordnung angebracht.

Unter der Annahme, dass das magnetische Material magnetisch gesättigt und rein in einer Richtung entlang der Achse der Magnetanordnung magnetisiert sei, kann $H_2(P)$ berechnet werden, indem auf der radial innen und auf der radial au-ßen liegenden Oberfläche *S=SI* beziehungsweise *S=SA* der ferromagnetischen Feldform-Vorrichtung P je ein zylindrischer Oberflächenstrom $J_S$ angenommen wird, dessen Beitrag $H_2(S)$ zu $H_2(P)$

$$H_2(S)\left[\frac{T}{m^2}\right] = \frac{\mu_0 \cdot J_S}{R_S^2}\left( Y_2\left(\frac{z1_S}{R_S}\right) - Y_2\left(\frac{z2_S}{R_S}\right)\right)$$

beträgt, mit

$$J_S\left[\frac{A}{m}\right] = \begin{cases} -\,sign(M_z)\cdot\dfrac{M_{Sat}}{\mu_0}\ \text{für S} = \text{SI} \\[2mm] sign(M_z)\cdot\dfrac{M_{Sat}}{\mu_0}\ \text{für S} = \text{SA} \end{cases}$$

$$\mu_0 = 4\pi\cdot 10^{-7}\left[\frac{V\cdot s}{A\cdot m}\right]$$

$sign(M_z)$: Vorzeichen der axialen Magnetisierung des Materials der ferromagnetischen Feldform-Vorrichtung $P$,

$M_{Sat}[T]$: Sättigungsmagnetisierung des Materials der ferromagnetischen Feldform-Vorrichtung P (2.15 $T$ für Weicheisen),

$R_S$ [$m$]: Radius der Zylinderfläche $S$,

$z1_S$ [$m$]: Abstand der Unterkante der Zylinderfläche $S$ zur Mittelebene der Magnetanordnung,

$z2_S$ [$m$]: Abstand der Oberkante der Zylinderfläche $S$ zur Mittelebene der Magnetanordnung,

$$Y_2(x) = \frac{3x}{4(x^2+1)^{5/2}}\;\cdot$$

$H_2(P)$ ist dann die Summe der beiden Beiträge $H_2(SI)$ und $H_2(SA)$ der Oberflächenströme $J_{SI}$ beziehungsweise $J_{SA}$. Nach dem selben Verfahren könnten auch Feldbeiträge $H_n(P)$ für andere Ordnungen $n$ berechnet werden. Die Funktionen $Y_n(X)$ lauten beispielsweise für $n=1,3$ oder $4$.

$$Y_1(x) = \frac{1}{2(x^2+1)^{3/2}}\;,$$

$$Y_3(x) = \frac{(4x^2-1)}{4(x^2+1)^{7/2}}$$

und

$$Y_4(x) = \frac{5x(4x^2-3)}{16(x^2+1)^{9/2}}\;\cdot$$

Der Feldbeitrag nullter Ordnung $H_0(P)$ entspricht der Feldstärke, um welche das Gesamtfeld im Zentrum des Arbeitsvolumens $AV$ durch die ferromagnetische Feldform-Vorrichtung P verändert wird. Er wird nach dem selben Verfahren berechnet, mit der Funktion

$$Y_0(x) = -\frac{x}{2(x^2+1)^{1/2}}\;\cdot$$

Damit dieses Verfahren zur Berechnung des Feldprofils der ferromagnetischen Feldform-Vorrichtung $P$ entlang der Achse der Magnetanordnung angewendet werden kann, muss das magnetische Material magnetisch gesättigt und rein in einer Richtung entlang der Achse der Magnetanordnung magnetisiert sein. Ob dies der Fall ist, hängt vom Hintergrundfeld ab, in welchem sich die ferromagnetische Feldform-Vorrichtung $P$ befindet. Dieses Feld wird von der Hauptspule *C1* und der aktiven Abschirmung *C2* erzeugt. Im Falle der erfindungsgemäßen Magnetanordnung *A3* ist dieses Feld im gesamten Volumen der ferromagnetischen Feldform-Vorrichtung *P* überall stärker als 1.25 Tesla, was ausreicht, um das verwendete Weicheisen weitgehend magnetisch zu sättigen. Die Feldkomponente in der Richtung entlang der Achse der Magnetanordnung ist im gesamten Volumen der ferromagnetischen Feldform-Vorrichtung *P* mindestens etwa zehn Mal stärker als die Komponente, welche radial von dieser Achse weg zeigt. Daher ist das Material nicht nur magnetisch gesättigt, sondern es ist auch rein in einer Richtung entlang der Achse der Magnetanordnung magnetisiert. Die Voraussetzungen zur Anwendung des obigen Verfahrens zur Berechnung des Feldprofils der ferromagnetischen Feldform-Vorrichtung *P* entlang der Achse der Magnetanordnung kann also im Falle der erfindungsgemäßen Magnetanordnung *A3* angewendet werden.

In einer erfindungsgemäßen Magnetanordnung, wie beispielsweise auch in der Ausführungsform *A3*, wird die ferromagnetische Feldform-Vorrichtung *P* radial zwischen dem radial inneren und äußeren Teilspulensystem *C1* beziehungsweise *C2* angebracht. Dies hat den Vorteil, dass sich in diesem Bereich die Feldbeiträge der beiden Teilspulensysteme konstruktiv überlagern, falls es sich beim radial äußeren Teilspulensystem um eine aktive Abschirmung handelt. Dadurch werden die Voraussetzungen für magnetische Sättigung der ferromagnetischen Feldform-Vorrichtung *P* verbessert. Außerdem ist die Richtung der Magnetisierung so, dass das Feld im Arbeitsvolumen *AV* durch die ferromagnetische Feldform-Vorrichtung *P* verstärkt wird, während das Streufeld abgeschwächt wird.

In der erfindungsgemäßen Magnetanordnung *A3* wurde die aktive Abschirmspule *C2* so dimensioniert, dass ihre axiale Länge ihrem Innendurchmesser entspricht. Spulenanordnungen mit diesem oder noch größerem Längen-zu-Radius-Verhältnis haben die Eigenschaft, radial zwischen Hauptspule *C1* und aktiver Abschirmung *C2* ein stärker axial ausgerichtetes Feld zu erzeugen als Spulen mit kleinerem Längen-zu-Radius-Verhältnis. Dadurch werden die Voraussetzungen für rein axiale Magnetisierung der ferromagnetischen Feldform-Vorrichtung *P* verbessert. Aus dem selben Grund wurde die axiale Länge der ferromagnetischen Feldform-Vorrichtung *P* wesentlich kürzer dimensioniert als diejenige der aktiven Abschirmung *C2,* denn die nichtaxialen Feldkomponenten eines Magnetspulensystems werden vor allem gegen die Spulenränder hin groß. Außerdem werden durch ferromagnetische Feldform-Vorrichtungen *P* mit einem Längen-zu-Radius-Verhältnis von eins oder kleiner die Feldinhomogenitäten $H_n(P)$ für $n = 2$ oder 4 am wirksamsten erzeugt, also mit minimalem Materialaufwand.

Um eine ferromagnetische Feldform-Vorrichtung *P* optimal dimensionieren zu können, müssen nicht nur die Beiträge $H_n(P)$ am gesamten Feldprofil entlang der Achse der Magnetanordnung im Bereich des Arbeitsvolumens AV für $n = 0, 1, 2, ...$ richtig berechnet werden, sondern auch der Beitrag zum Streufeld außerhalb der Magnetanordnung muss bestimmt werden können. Eine einfache Methode basiert darauf, das magnetische Dipolmoment $m(P)$ der ferromagnetischen Feldform-Vorrichtung *P* wie folgt zu berechnen:

$$m(P)\left[Am^2\right] = \frac{M_{Sat}}{\mu_0} \cdot V_P \cdot sign\left(M_z\right) \, ,$$

mit

$V_P[m^3]$: Volumen der ferromagnetischen Feldform-Vorrichtung *P*.

Die übrigen verwendeten Größen haben die oben genannten Bedeutungen. In genügend großem Abstand von der Magnetanordnung kann das Feld der ferromagnetischen Feldform-Vorrichtung *P* nun mit den bekannten Formeln für das Feld eines magnetischen Dipols mit dem magnetischen Dipolmoment $m(P)$ berechnet werden.

**Patentansprüche**

1. Magnetanordnung mit einem supraleitenden Magnetspulensystem (*M*) zur Erzeugung eines Magnetfeldes in Richtung einer *z*-Achse in einem auf der *z*-Achse um *z = 0* angeordneten Arbeitsvolumen (*AV*), wobei das Feld der Magnetanordnung im Arbeitsvolumen (*AV*) einen Anteil H2, d.h. eine H2-Inhomogenität aufweist, der entlang der *z*-Achse eine quadratische Ortsabhängigkeit aufweist, wobei das supraleitende Magnetspulensystem *(M)* ein radial inneres Teilspulensystem (*C1*) und ein dazu koaxiales radial äußeres Teilspulensystem *(C2)* umfasst, sowie mit einer um die *z*-Achse insbesondere zylindersymmetrisch angeordneten Feldform-Vorrichtung (*P*) aus ferromagnetischem Material, welche sich radial zwischen dem radial inneren und dem radial äußeren Teilspulensystem *(C1, C2)* befindet und mit den beiden Teilspulensystemen *(C1, C2)* koaxial ist,
**dadurch gekennzeichnet,**
**dass** das radial innere Teilspulensystem *(C1)* im Arbeitsvolumen *(AV)* ein Feld mit einer verschwindend kleinen H2-Inhomogenität, d.h. ein homogenes Feld erzeugt, während das radial äußere Teilspulensystem *(C2)* für sich im Arbeitsvolumen *(AV)* ein Feld mit einer großen H2-Inhomogenität, d.h. ein inhomogenes Feld erzeugt, dass das radial äußere Teilspulensystem *(C2)* zusammen mit der ferromagnetischen Feldform-Vorrichtung *(P)* im Arbeitsvolumen *(AV)* ein homogenes Feld erzeugt, und dass das ferromagnetische Material der Feldform-Vorrichtung *(P)* magnetisch gesättigt ist und seine Magnetisierung in eine Richtung entlang der *z*-Achse weist.

2. Magnetanordnung nach Anspruch 1, **dadurch gekennzeichnet, dass** die beiden Teilspulensysteme (*C1*, C2) im Arbeitsvolumen *(AV)* je ein Magnetfeld mit entgegengesetzter Richtung entlang der *z*-Achse erzeugen.

3. Magnetanordnung nach Anspruch 2, **dadurch gekennzeichnet, dass** das radial innere Teilspulensystem (*C1*) ein entgegengesetzt gleiches magnetisches Dipolmoment aufweist wie das radial äußere Teilspulensystem *(C2)* zusammen mit der Feldform-Vorrichtung *(P)*.

4. Magnetanordnriung nach einem der vorhergehenden Ansprüche, **dadurch gekennzeichnet, dass** die Feldform-Vorrichtung *(P)* aus einem Ring der axialen Länge *LP* mit Innenradius *RiP* besteht, wobei *LP* gleich *RiP* ist.

5. Magnetanordnung nach einem der Ansprüche 1 bis 3, **dadurch gekennzeichnet, dass** die Feldform-Vorrichtung *(P)* aus zwei Ringen der axialen Länge *LQ* mit Innenradius *RiP* besteht, welche im Abstand *DQ* symmetrisch um *z* = 0 angeordnet sind, wobei *DQ < 0.5·RiP* und (*DQ* + 2 *LQ*) gleich *RiP* ist.

6. Verfahren zur Dimensionierung einer ferromagnetischen Feldform-Vorrichtung, wobei die ferromagnetische Feldform-Vorrichtung Teil einer Magnetanordnung nach einem der vorangehenden Ansprüche ist, wobei die ferromagnetische Feldformvorrichtung magnetisch gesättigt, in Richtung entlang der *z*-Achse magnetisiert und bezüglich der *z*-Achse zylindersymmetrisch ist, **dadurch gekennzeichnet, dass** die ferromagnetische Feldform-Vorrichtung so dimensioniert wird, dass die Feldinhomogenitäten $H_n(C2)$ des radial äußeren Teilspulensystems *(C2)*, welche entlang der *z*-Achse mit der *n*-ten Potenz von *z* variieren, für n = *1, 2, 3* und *4* durch entsprechende Feldinhomogenitäten $H_n(P) = -H_n(C2)$ der ferromagnetischen Feldform-Vorrichtung *(P)* kompensiert werden, wobei die Feldinhomogenitäten $H_n(P)$ berechnet werden, indem auf jeder radial innen und auf jeder radial außen liegenden Oberfläche $S = SI_k$ beziehungsweise $S = SA_m$ der ferromagnetischen Feldform-Vorrichtung *(P)* ein zylindrischer Oberflächenstrom $J_S$ angenommen wird, dessen Beitrag $H_n(S)$ zur Feldinhomogenität $H_n(P)$

$$H_n(S)\left[\frac{T}{m^n}\right] = \frac{\mu_0 \cdot J_S}{R_S^n}\left(Y_n\left(\frac{z1_S}{R_S}\right) - Y_n\left(\frac{z2_S}{R_S}\right)\right)$$

beträgt, mit

$$J_S\left[\frac{A}{m}\right] = \begin{cases} -sign(M_z)\cdot\dfrac{M_{Sat}}{\mu_0} & \text{für } S = SI_k \\ sign(M_z)\cdot\dfrac{M_{Sat}}{\mu_0} & \text{für } S = SA_m \end{cases}$$

$$\mu_0 = 4\pi \cdot 10^{-7}\left[\frac{Vs}{Am}\right]$$

$sign(M_z)$: Vorzeichen der axialen Magnetisierung des ferromagnetischen Materials der Feldform-Vorrichtung *(P)*,
$M_{Sat}[T]$: Sättigungsmagnetisierung des ferromagnetischen Materials der Feldform-Vorrichtung *(P)*,
$R_S$ *[m]*: Radius der Zylinderfläche *S*,
$z1_S$ *[m]*: Abstand der Unterkante der Zylinderfläche *S* zu *z* = 0,
$z2_S$ *[m]*: Abstand der Oberkante der Zylinderfläche *S* zu *z* = 0,

$$Y_1(x) = \frac{1}{2(x^2+1)^{3/2}},$$

$$Y_2(x) = \frac{3x}{4(x^2+1)^{5/2}},$$

$$Y_3(x) = \frac{(4x^2-1)}{4(x^2+1)^{7/2}},$$

$$Y_4(x) = \frac{5x(4x^2-3)}{16(x^2+1)^{9/2}},$$

und indem die Beiträge $H_n(S)$ aller Oberflächenströme $J_S$ addiert werden.

**Claims**

1. A magnet configuration comprising a superconducting magnet coil system (M) for generating a magnetic field in the direction of a z axis in a working volume (AV) disposed on the z axis about z=0, wherein the field of the magnet configuration in the working volume (AV) comprises a portion H2, i.e. a H2 inhomogeneity, with a square spatial dependence along the z axis, wherein the superconducting magnet coil system (M) comprises a radially inner partial coil system (C1) and a radially outer partial coil system (C2) which is coaxial thereto, and a field forming device (P) of ferromagnetic material which is disposed, in particular, cylinder symmetrically about the z axis, and which is disposed radially between the radially inner and the radially outer partial coil system (C1, C2) and is coaxial to the two partial coil systems (C1, C2),
**characterized in that**
the radially inner partial coil system (C1) in the working volume (AV) generates a field with a negligibly small H2 inhomogeneity, i.e. a homogeneous field, while the radially outer partial coil system (C2) generates a field with a large H2 inhomogeneity, i.e. an inhomogeneous field, in the working volume (AV), the radially outer partial coil system (C2) generates a homogeneous field together with the ferromagnetic field forming device (P) in the working volume (AV), wherein the ferromagnetic material of the field forming device (P) is magnetically saturated with its magnetization being directed in a direction along the z axis.

2. The magnet configuration according to claim 1, **characterized in that** the two partial coil systems (C1, C2) in the working volume (AV) each generate a magnetic field of opposite directions along the z axis.

3. The magnet configuration according to claim 2, **characterized in that** the radially inner partial coil system (C1) comprises a magnetic dipole moment which is oppositely identical to that of the radially outer partial coil system (C2) in conjunction with the field forming device (P).

4. The magnet configuration according to any one of the preceding claims, **characterized in that** the field forming device (P) consists of a ring having an axial length LP and an inner radius RiP, wherein LP is equal to RiP.

5. The magnet configuration according to any one of the claims 1 through 3, **characterized in that** the field forming device (P) consists of two rings having an axial length LQ and an inner radius RiP, which are disposed at a separation DQ symmetrically about z=0, wherein DQ<0.5 RiP and (DQ+2LQ) equals RiP.

6. Method for dimensioning a ferromagnetic field forming device, wherein the ferromagnetic field forming device is part of a magnet configuration according to any one of the preceding claims, wherein the ferromagnetic field forming device is magnetically saturated, magnetized in the direction along the z axis, and is cylindrically symmetric relative to the z axis, **characterized in that** the ferromagnetic field forming device is dimensioned in such a manner that the field inhomogeneities $H_n(C2)$ of the radially outer partial coil system (C2) which vary along the z axis with the nth power of z, are compensated for n = 1, 2, 3 and 4 by corresponding field inhomogeneities $H_n(P) = -H_n(C2)$ of the ferromagnetic field forming device (P), wherein said field inhomogeneities $H_n(P)$ are calculated by assuming a cylindrical surface current $J_S$ on each radially inner and each radially outer surface $S = SI_k$ and $S = SA_m$ of the ferromagnetic field forming device (P) with a contribution $H_n(S)$ to the field inhomogeneity $H_n(P)$ of

$$H_n(S)\left[\frac{T}{m^n}\right] = \frac{\mu_0 \cdot J_S}{R_S^n}\left(Y_n\left(\frac{z1_S}{R_S}\right) - Y_n\left(\frac{z2_S}{R_S}\right)\right)$$

with

$$J_S\left[\frac{A}{m}\right] = \begin{cases} -sign(M_z) \cdot \dfrac{M_{Sat}}{\mu_0} \text{ für } S = SI_k \\[3mm] sign(M_z) \cdot \dfrac{M_{Sat}}{\mu_0} \text{ für } S = SA_m \end{cases}$$

$$\mu_0 = 4\pi \cdot 10^{-7}\left[\frac{Vs}{Am}\right]$$

$sign(M_z)$: Sign of the axial magnetization of the ferromagnetic material of the field forming device *(P)*,
$M_{Sat}$ [*T*]: Saturation magnetization of the ferromagnetic material of the field forming device *(P)*,
$R_S$ [*m*]: Radius of the cylindrical surface *S*,
$z1_S$ [*m*]: Distance between the lower edge of the cylindrical surface *S* and *z = 0*,
$z2_S$ [*m*]: Distance between the upper edge of the cylindrical surface *S* and *z = 0*,

$$Y_1(x) = \frac{1}{2(x^2+1)^{3/2}} ,$$

$$Y_2(x) = \frac{3x}{4(x^2+1)^{5/2}} ,$$

$$Y_3(x) = \frac{(4x^2-1)}{4(x^2+1)^{7/2}} ,$$

$$Y_4(x) = \frac{5x(4x^2-3)}{16(x^2+1)^{9/2}} ,$$

and by adding together the contributions $H_n(S)$ of all surface currents $J_S$.

**Revendications**

1. Arrangement magnétique supraconducteur comportant un système de bobines magnétiques supraconductrices *(M)* pour générer un champ magnétique en direction d'un axe *z* dans un volume de travail *(AV)* situé sur l'axe *z* autour de *z = 0*, le champ de l'arrangement magnétique présentant dans le volume de travail *(AV)* une composante H2, c.-à-d. une inhomogénéité H2 qui présente une dépendance locale quadratique le long de l'axe *z*, le système de bobines magnétiques supraconductrices *(M)* comprenant un sous-système de bobines (C1) radialement intérieur et un sous-système de bobines (C2) radialement extérieur coaxial au premier, ainsi que comportant un dispositif de configuration de champ *(P)* en matériau ferromagnétique, disposé en particulier de manière cylindrosymétrique autour de l'axe *z*, lequel se trouve radialement entre les sous-systèmes de bobines (C1, C2) radialement intérieur et radialement extérieur et est coaxial aux deux sous-systèmes de bobines (C1, C2),
   **caractérisé par le fait**
   **que** le sous-système de bobines (C1) radialement intérieur génère dans le volume de travail *(AV)* un champ avec une inhomogénéité H2 extrêmement petite, c.-à-d. un champ homogène, tandis que le sous-système de bobines *(C2)* radialement extérieur génère dans le volume de travail *(AV)* un champ avec une grande inhomogénéité H2, c.-à-d. un champ inhomogène, que le sous-système de bobines *(C2)* radialement extérieur génère conjointement avec le dispositif de configuration de champ *(P)* ferromagnétique dans le volume de travail *(AV)* un champ homogène, et que le matériau ferromagnétique du dispositif de configuration de champ *(P)* est magnétiquement saturé et est magnétisé dans une direction s'étendant le long de l'axe *z*.

2. Arrangement magnétique selon la revendication 1, **caractérisé par le fait que** les deux sous-systèmes de bobines (C1, C2) génèrent dans le volume de travail *(AV)* des champs magnétiques de sens opposés le long de l'axe *z*.

3. Arrangement magnétique selon la revendication 2, **caractérisé par le fait que** le sous-système de bobines (C1) radialement intérieur présente un moment dipolaire magnétique opposé et égal à celui du sous-système de bobines *(C2)* radialement extérieur conjointement avec le dispositif de configuration de champ *(P)*.

4. Arrangement magnétique selon l'une des revendications précédentes, **caractérisé par le fait que** le dispositif de configuration de champ *(P)* se compose d'un anneau de longueur axiale *LP* et de rayon intérieur *RiP, LP* étant égal à *RiP*.

5. Arrangement magnétique selon l'une des revendications 1 à 3, **caractérisé par le fait que** le dispositif de configuration de champ *(P)* se compose de deux anneaux de longueur axiale *LQ* et de rayon intérieur *RiP* qui sont disposés symétriquement autour de *z = 0* à une distance *DQ*, avec *DQ < 0,5·RiP* et *(DQ + 2 LQ)* étant égal à *RiP*.

6. Procédé de dimensionnement d'un dispositif de configuration de champ ferromagnétique, le dispositif de configuration de champ ferromagnétique faisant partie d'un arrangement magnétique selon l'une des revendications précédentes, le dispositif de configuration de champ ferromagnétique étant magnétiquementsaturé, magnétisé dans une direction s'étendant le long de l'axe *z* et cylindrosymétrique par rapport à l'axe *z*, **caractérisé par le fait que** le dispositif de configuration de champ ferromagnétique est dimensionné de telle manière que les inhomogénéités de champ $H_n(C2)$ du sous-système de bobines *(C2)* radialement extérieur qui varient le long de l'axe *z* avec la puissance *nième* de *z* sont compensées, pour *n = 1, 2, 3* et *4* par des inhomogénéités de champ correspondantes $H_n(P) = -H_n(C2)$ du dispositif de configuration de champ ferromagnétique *(P)*, les inhomogénéités de champ $H_n(P)$ étant calculées en supposant un courant de surface $J_S$ cylindrique sur chaque surface située radialement intérieurement et radialement extérieurement $S = SI_k$ respectivement $S = SA_m$ du dispositif de configuration de champ ferromagnétique *(P)*, dont la valeur $H_n(S)$ par rapport à l'inhomogénéité de champ $H_n(P)$ est

$$H_n(S)\left[\frac{T}{m^n}\right] = \frac{\mu_0 \cdot J_S}{R_S^n}\left(Y_n\left(\frac{z1_S}{R_S}\right) - Y_n\left(\frac{z2_s}{R_S}\right)\right)$$

avec

$$J_S\left[\frac{A}{m}\right] = \begin{cases} -sign(M_z) \cdot \dfrac{M_{Sat}}{\mu_0} \; pour \; S = SI_k \\[3mm] sign(M_z) \cdot \dfrac{M_{Sat}}{\mu_0} \; pour \; S = SA_m \end{cases}$$

$$\mu_0 = 4\pi \cdot 10^{-7} \left[\frac{V_s}{A_m}\right]$$

$sign(M_z)$ : signe de la magnétisation axiale du matériau ferromagnétique du dispositif de configuration de champ ferromagnétique (P),

$M_{Sat}[T]$ : magnétisation de saturation du matériau ferromagnétique du dispositif de configuration de champ ferromagnétique (P),

$R_S[m]$ : rayon de la surface cylindrique $S$,

$z1_S[m]$ : distance du bord inférieur de la surface cylindrique $S$ par rapport à $z = 0$,

$z2_S[m]$ : distance du bord supérieur de la surface cylindrique $S$ par rapport à $z = 0$,

$$Y_1(x) = \frac{1}{2(x^2+1)^{3/2}} \; ,$$

$$Y_2(x) = \frac{3x}{4(x^2+1)^{5/2}} \; ,$$

$$Y_3(x) = \frac{(4x^2-1)}{4(x^2+1)^{7/2}} \; ,$$

$$Y_4(x) = \frac{5x(4x^2-3)}{16(x^2+1)^{9/2}} \; ,$$

et en additionnant les valeurs $H_n(S)$ de tous les courants de surface $J_S$.

Fig. 1

Fig. 2

Fig. 3